# EUROPÄISCHE PATENTSCHRIFT

(11) **EP 1 648 029 B1**
(45) Veröffentlichungstag und Bekanntmachung des Hinweises auf die Patenterteilung: **02.07.2008**
(21) Anmeldenummer: 05017563.7
(22) Anmeldetag: 12.08.2005
(51) Int. Cl.: H01L 23/48, H01L 25/07

(54) **Kontakteinrichtung für Leistungshalbleitermodule und Halbleiter-Scheibenzellen**
Contact device for power semiconductor modules and disc-shaped semiconductor cells
Dispositif de contact pour modules semiconducteur de puissance et cellules discoides semiconductrices

(30) Priorität: 16.10.2004 DE 102004050588
(43) Veröffentlichungstag der Anmeldung: 19.04.2006
(73) Patentinhaber: Semikron Elektronik GmbH & Co. KG Patentabteilung, 90431 Nürnberg (DE)
(72) Erfinder: Kroneder, Christian, 90596 Schwanstetten (DE); Tauscher, Björn, 91183 Abenberg (DE)

(56) Entgegenhaltungen:
- EP-A- 1 291 914
- DE-A1- 1 564 567
- DE-A1- 4 227 063
- DE-A1- 10 017 319
- DE-A1- 19 651 632
- DE-C1- 10 231 219
- GB-A- 1 031 233
- GB-A- 1 078 342
- US-A- 4 263 607

## Beschreibung

Es wird eine Kontakteinrichtung für den Steueranschluss von Leistungshalbleiterbauelementen in Scheibenzellen und Leistungshalbleitermodulen beschrieben. Derartige Kontakteinrichtungen sind Teil von Scheibenzellen wie sie beispielhaft bekannt sind aus Heumann, "Grundlagen der Leistungselektronik", Teubner Verlag, 6. Auflage, ISBN 3-519-06110-4, Seite 27 und von vorzugsweise druckkontaktierten Leistungshalbleitermodulen wie sie beispielhaft aus der DE 196 51 632 A1 bekannt sind.

Druckkontaktierte Leistungshalbleitermodule wie beispielhaft diejenigen gemäß der DE 196 51 632 A1 sind für sehr hohe Leistungsanforderungen hinsichtlich Stromtragfähigkeit und Zuverlässigkeit geeignet. Daher kommt auch dem Steueranschluss hier eine ebenso bedeutende Rolle zu wie den Leistungsanschlüssen. Druckkontaktverbindungen der Leistungsanschlüsse sind aus der Herstellung von Halbleitermodulen als Verbindungstechnik hinlänglich bekannt und vielfach bewährt. Demgegenüber gibt es für die Kontaktverbindung von Steueranschlüssen eine Vielzahl von Varianten mit unterschiedlich hohem Fertigungsaufwand und nicht direkt damit einhergehend unterschiedlich hoher Zuverlässigkeit.

Bekannt sind Lötverbindungen zwischen dem Steueranschluss des Leistungshalbleiterbauelements. Ebenso sind verschiedene Arten von federbelasteten Druckkontaktierungen bekannt, denen gemeinsam ist, dass sie eine komplexe, häufig nur manuell mögliche, Herstellung bedingen und / oder deren Zuverlässigkeit ungenügend ist.
Beispielhaft aus der US 4,263,607 ist eine federbelastete Druckkontakteinrichtung bekannt, bei der ein Anschlussdraht mit einem halbkugelförmigen Metallformteil versehen ist, welches der Kontaktierung mit einem Steueranschluss dient. Hierbei wird mittels einer Feder, die konzentrisch um einen Teil des Anschlussdrahtes angeordnet ist und sich gegen das halbkugelförmige Metallformteil und gegen ein Widerlager abstützt, Druck auf dieses Metallformteil eingeleitet, wodurch der elektrische Kontakt hergestellt wird.

Der Erfindung liegt die Aufgabe zugrunde eine Kontakteinrichtung des Steueranschlusses von Leistungshalbleiterbauelementen in Scheibenzellen und Leistungshalbleitermodulen vorzustellen, die universell einsetzbar ist, einen dauerhaft sicheren elektrischen Kontakt gewährleistet und einer einfachen Montage zugänglich ist.

Die Aufgabe wird erfindungsgemäß gelöst, durch eine Kontakteinrichtung mit den Merkmalen des Anspruchs 1. Bevorzugte Ausführungsformen sind in den Unteransprüchen beschrieben.

Der Grundgedanke der Erfindung geht aus von einem Leistungshalbleitermodul, vorzugsweise in Druckkontaktierung mit einem oder mehreren Leistungshalbleiterbauelementen oder einer Scheibenzelle. In einer Scheibenzelle ist typischerweise nur ein Leistungshalbleiterbauelement angeordnet, allerdings gibt es Sonderformen mit einer Mehrzahl von Leistungshalbleiterbauelementen in einem Gehäuse.

Die Erfindung bezieht sich auf Leistungshalbleitermodule oder auf Scheibenzellen mit mindestens einem gesteuerten Leistungshalbleiterbauelement, wie einem Thyristor oder einem Transistor. Diese weisen einen Steueranschluss auf, der von außerhalb des Leistungshalbleitermoduls oder der Scheibenzelle mit einem Steuersignal beaufschlagt wird.

Häufig werden die Halbleiterbauelemente in Leistungshalbleitermodulen und Scheibenzellen beidseitig mit je einem flächigen Metallkörper verbunden, dessen Wärmeausdehnungskoeffizient zwischen dem Wärmeausdehnungskoeffizienten des Halbleiterbauelements und dem Wärmeausdehnungskoeffizienten einer anschließenden Kontakteinrichtung der Leistungsanschlüsse liegt, um den thermischen Stress für das Halbleiterbauelement zu verringern. Die Verbindung des Halbleiterbauelements mit den flächigen Metallkörpern, die vorzugsweise aus Molybdän bestehen, kann durch unterschiedliche Verfahren realisiert werden, beispielhaft durch Verlöten, Verkleben oder Druckkontaktierung der beiden Partner. Der flächige Metallkörper weist typischerweise eine Dicke in der Größenordnung von einigen zehntel bis einigen Millimetern auf.

Der erfindungsgemäßen Kontakteinrichtung zur Kontaktierung des Steueranschlusses des mindestens einen Leistungshalbleiterbauelements ist auf der den Haupt- (Leistungs-) und den Steueranschluss tragenden Hauptfläche ein Formkörper, beispielhaft den oben genannten flächigen Metallkörper, zugeordnet. Dieser Formkörper weist im Bereich oberhalb des Steueranschlusses eine Ausnehmung auf und diese Ausnehmung weist wiederum ein Widerlager auf.

Die Kontakteinrichtung selbst besteht aus einer Kontaktfeder mit einem stiftartigen Fortsatz an demjenigen Federende, der den Steueranschluss kontaktiert. Weiterhin weist sie eine direkt oder über ein Metallformteil gebildete Verbindung mit einem Anschlusskabel zur externen Verbindung am anderen Federende auf. Die Kontaktfeder und das optionale Metallformteil sind in einer Isolierstoffhülse angeordnet, wobei diese Isolierstoffhülse mindestens eine Rastnase aufweist die zusammen mit dem Widerlager des Formkörpers eine Schnapp- Rast- Verbindung bildet.

Der erfinderische Gedanke wird anhand der Ausführungsbeispiele in den Fig. 1 bis 5 näher erläutert.

Fig. 1 zeigt eine Ausgestaltung einer Scheibenzelle nach dem Stand der Technik.

Fig. 2 zeigt einen Schnitt durch eine Ausgestaltung eines druckkontaktierten Leistungshalbleiermoduls nach dem Stand der Technik.

Fig. 3 zeigt eine erfindungsgemäße Kontakteinrichtung in einem Leistungshalbleitermodul.

Fig. 4 zeigt eine dreidimensionale Explosionsdarstellung einer erfindungsgemäßen Kontakteinrichtung.

Fig. 5 zeigt eine dreidimensionale Explosionsdarstellung eines Leistungshalbleitermoduls mit einer erfindungsgemäßen Kontakteinrichtung.

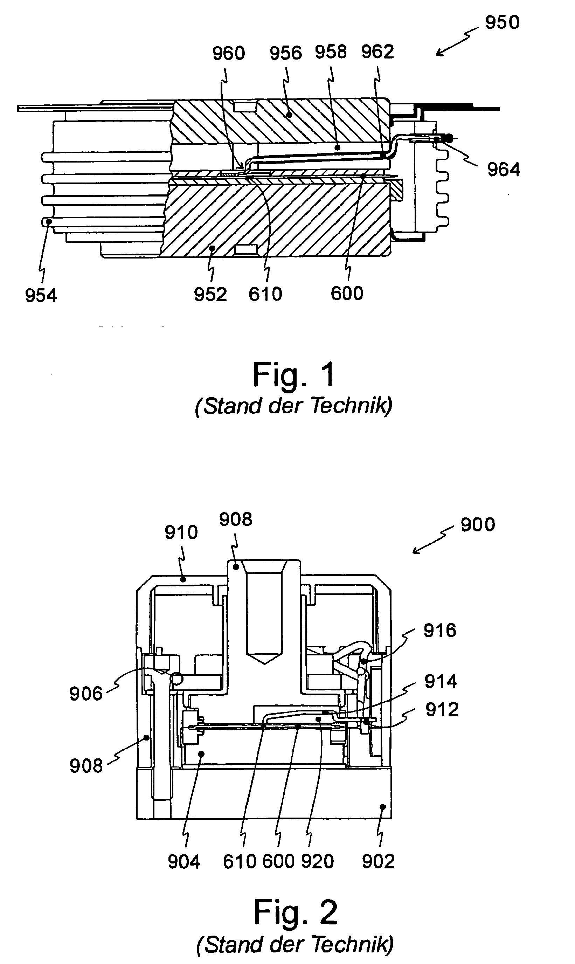

Fig. 1 zeigt einen Teilschnitt durch eine Scheibenzelle (950) gemäß dem Stand der Technik. Diese weist einen Isolierstoffkörper (954) vorzugsweise aus Keramik auf. Dieser Isolierstoffkörper (954) bildet das Gehäuse der Scheibenzelle (950), ihre obere und untere Abdeckung (956, 952) sind als Metallformkörper ausgebildet. Im Inneren der Scheibenzelle (950) ist ein Leistungshalbleiterbauelement (600) angeordnet.

In dieser Ausgestaltung der Scheibenzelle (950) weist der eine Metallformkörper (956) eine Ausnehmung (958) auf. In dieser Ausnehmung (958) ist die Gatekontakteinrichung angeordnet. Diese ist als federndes Drahtelement (962) mit einer isolierenden Umhüllung ausgebildet. Die Isolierung überdeckt ausschließlich den Teil des Drahtelements (962), der mit dem Metallformkörper (956) in Kontakt kommen kann. Das erste Ende des Drahtelements (962) ist in einer mit einer Metallhülse (964) versehenen Ausnehmung des Isolierstoffkörpers (956) angeordnet und mit dieser somit elektrisch leitend verbunden. Das zweite Ende (960) des Drahtelements (962) liegt auf dem Gateanschluss des Leistungshalbleiterbauelements (600) auf. Durch die Anordnung in der Metallhülse (964) und die Form des Drahtelements (962) ergibt sich eine Federwirkung mit einer Krafteinleitung auf das zweite Ende (960) des Drahtelements (962) in Richtung des Leistungshalbleiterbauelements (600).

Nachteilig an dieser Ausgestaltung der Scheibenzelle (950) ist, dass der Metallformkörper (956) eine radial nach außen laufende Ausnehmung (958) zur Aufnahme des Drahtelements (962) aufweisen muss. Diese ist nicht kosteneffizient herstellbar, ebenso wenig ist die Montage der Kontakteinrichtung automatisierbar.

Fig. 2 zeigt einen Schnitt durch eine Ausgestaltung eines druckkontaktierten Leistungshalbleitermoduls (900) nach dem Stand der Technik. Dargestellt ist hierbei eine metallische Grundplatte (902), ein Kunststoffgehäuse (908) und ein Kunststoffdeckel (910). Auf der Grundplatte (902) ist nachfolgend einer Isolierschicht ein erster Metallformkörper (904) angeordnet, auf diesem ist ein Leistungshalbleiterbauelement (600) und hierüber ein zweiter metallischer Formkörper (908) angeordnet. Dieser zweite metallische Formkörper (908) wird mittels einer Druckkontakteinrichtung (906) mit Druck beaufschlagt und drückt somit das Halbleiterbauelement (600) gegen den ersten Formkörper (904) und diesen gegen die Grundplatte (902). Somit ist ein sicherer elektrischer Kontakt des Halbleiterbauelements (600) zu den beiden Formkörper (904, 908) und zusätzlich ein thermischer Kontakt zur Grundplatte (902) sichergestellt. Die beiden metallischen Formkörper (904, 908) dienen somit der Kontaktierung der Hauptanschlüsse (Leitungsanschlüsse).

Der Steueranschluss (610) des Leistungshalbleiterbauelements (600) wird mittels einer Kontakteinrichtung kontaktiert. Diese Kontakteinrichtung besteht aus einem metallischen Drahtelement (914), der in einer Halteeinrichtung (912) des Gehäuses fixiert ist. Von dieser Halteeinrichtung (912) ausgehend ist eine elektrisch isolierte Drahtverbindung (916) zu einem äußeren Anschluss vorgesehen. Der zweite metallische Formkörper (908) weist eine Aussparung (920) auf, in deren Verlauf das Drahtelement (914) angeordnet ist und dort den Steueranschluss (610) kontaktiert. Das Drahtelement (914) sowie dessen Halteeinrichtung (912) sind derart ausgestaltet, dass das Drahtelement (914) eine Federkraft aufbaut, die auf das Leistungshalbleiterbauelement (600) hin gerichtet ist. Somit ist auch der Steueranschluss des Leistungshalbleitermoduls (900) in Druckkontakttechnik ausgeführt.

Nachteilig an dieser Ausgestaltung der Kontakteinrichtung ist allerdings, dass durch die Ausnehmung (920) im zweiten Formkörper (908) die Druckeinleitung auf das Leistungshalbleiterbauelement (600) nicht radialsymmetrisch erfolgt. Weiterhin nachteilig ist, dass für verschiedene Leistungsklassen des Leistungshalbleitermoduls (900) und damit einhergehend unterschiedliche Durchmesser des Leistungshalbleiterbauelements (600) die Kontakteinrichtungen unterschiedlich ausgebildet sind. Der Montageaufwand der Kontakteinrichtung steht hier ebenfalls einer kostengünstigen Fertigung entgegen.

Nachteilig an den Ausgestaltungen der Kontakteinrichtungen für Scheibenzellen nach Fig. 1 und Leistungshalbleitermodulen nach Fig. 2 ist weiterhin, dass der Federarm also die laterale Ausdehnung zwischen der Halterung (964, 912) und der Kontaktstelle also dem Steueranschluss (610) des Leistungshalbleiterbauelements (600) sehr groß ist. Unter dieser Ausgestaltung des federnden Drahtelements (962, 914) leidet die Kontaktsicherheit, da die Homogenität der Federkraft über die Produktion einer Vielzahl von Scheibenzellen bzw. Leistungshalbleitermodulen nur mit erheblichem Aufwand gegeben ist.

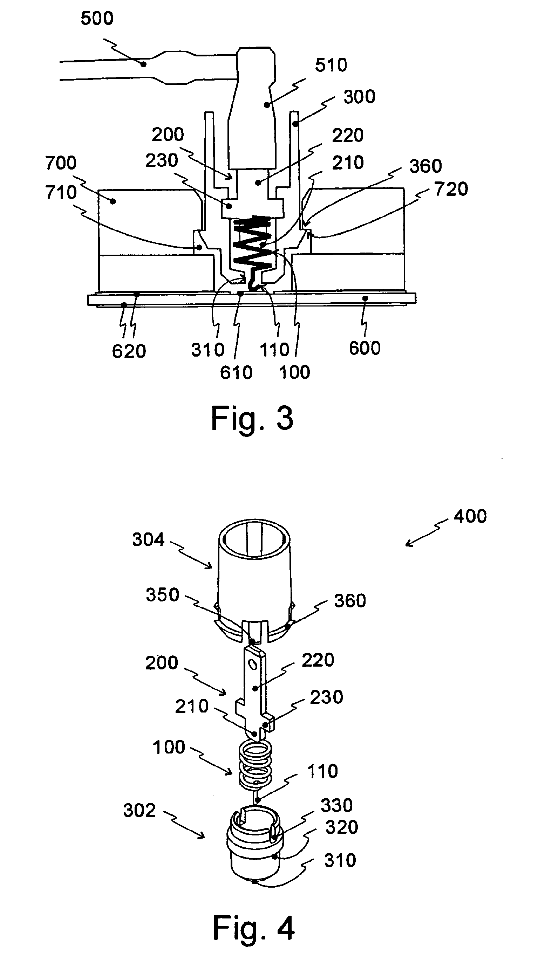

Fig. 3 zeigt eine erfindungsgemäße Kontakteinrichtung in einem Leistungshalbleitermodul. Dargestellt ist ein Leistungshalbleiterbauelement (600) mit einem Steueranschluss (610) zentral auf dessen erster Hauptfläche angeordnet sowie einem ersten und einem zweiten Leistungsanschluss (620) angeordnet auf den beiden gegenüberliegenden Hauptflächen des Leistungshalbleiterbauelements (600). Über der ersten Hauptfläche des Leistungshalbleiterbauelements (600) ist ein metallischer Formkörper (700), gebildet aus dem Sandwich zweier Teilformkörper angeordnet. Dieser Formkörper (700) weist eine runde zentrale Ausnehmung (710) auf, die eine Kante (720) aufweist.

Die Kontakteinrichtung selbst besteht aus einer Isolierstoffhülse (300), bestehend aus einem thermo- oder vorzugsweise duroplasten Kunststoff, einem Federelement (100) und einem als Stecker ausgebildeten Metallformteil (200). Die Kunststoffhülse (300) dient der elektrischen Isolation des Steuersignals vom Leistungsanschluss, der durch den metallischen Formkörper (700) gebildet wird. Die Kunststoffhülse (300) weist zwei Rastnasen (360) auf. Diese Rastnasen (360) bilden mit der als Widerlager dienenden Kante (720) des metallischen Formkörpers (700) eine Schnapp- Rast- Verbindung. Somit ist eine einfache Montage der Kontakteinrichtung in dem metallischen Formkörper (700) möglich.

Im Inneren der Kunststoffhülse (300) ist die als Tonnenfeder ausgebildete Kontaktfeder (100) angeordnet. Dieses weist an ihrer dem Leistungshalbleiterbauelement (600) zugewandten Seite einen zentral zur Federachse angeordneten stiftartigen Fortsatz (110) mit unterschiedlich gestaltetem Ende auf. Diese kann beispielhaft stumpf, ballig oder als Bogen, wie dargestellt, ausgebildet sein. Der Fortsatz (110) durchdringt die Kunststoffhülse (300), wobei diese derart ausgebildet ist, dass das Federelement (100) in Richtung des Steueranschlusses (610) gegen Herausfallen gesichert ist. Der Fortsatz (110) dient der Kontaktierung des Steueranschlusses (610) des Leistungshalbleiterbauelements (600). Der federnde Abschnitt der Kontaktfeder (100) dient der über die Lebensdauer der Scheibenzelle bzw. des Leistungshalbleitermoduls konstanten Druckeinleitung und damit sicheren Kontaktierung des Steueranschlusses (610).

Das ebenfalls im Inneren der Kunststoffhülse (300) angeordnete Metallformteil (200) dient der elektrischen Verbindung der Kontaktfeder (100) mit dem externen Steueranschluss der Scheibenzelle bzw. des Leistungshalbleiterbauelements. Hierzu weist das Metallformteil (200) einen ersten Zapfen (210) auf, der zur Führung des Metallformteils (200) dient und in den Innenbereich der Kontaktfeder (100) hineinreicht. Weiterhin sind zwei weitere Zapfen (230) rechtwinkelig zum ersten Zapfen (210) angeordnet, die einen Anschlag für die Kontaktfeder (100) bilden und somit zum Druckaufbau dienen.

Zur Verbindung mit einem Anschlusskabel (500), das eine Steckerhülse (510) aufweist, weist das Metallformteil (200) einen zweiten Zapfen (220) auf, der als Stecker ausgebildet ist. Somit wird die Verbindung zu einem externen Anschluss gebildet.

Alternativ und kostengünstiger ist eine Ausgestaltung der Kontakteinrichtung derart, dass die Kunststoffhülse (300) derart ausgebildet ist, dass sie selbst ein Widerlager für das Federelement aufweist und das dem Leistungshalbleiterbauelement abgewandte Federende mittels einer Löt-, oder Schweißverbindung direkt mit dem Anschlusskabel (500) verbunden ist.

Fig. 4 zeigt eine dreidimensionale Explosionsdarstellung einer erfindungsgemäßen Kontakteinrichtung (400). Dargestellt sind hier die Kunststoffhülse (300), die Kontaktfeder (100) und das Metallformteil (200). Die Kunststoffhülse (300) ist hierbei zweistückig ausgebildet. Eine erste Teilhülse (302) bildet den Teil der Kunststoffhülse (300), der dem Leistungshalbleiterbauelement (600) zugewandt ist. Sie ist derart ausgebildet dass die mit einem stumpfen Ende versehene Kontaktfeder (100) in Richtung des Steueranschlusse (610) gegen Herausfallen gesichert ist und weist hierzu eine Ausnehmung (310) auf, die ca. 0,2mm größer ist als der Durchmesser des stiftartigen Fortsatzes (110) der Kontaktfeder. Weiterhin weist die erste Teilhülse (302) eine Rastkante (320) sowie zwei Ausnehmungen (330) am oberen Rand auf, deren Funktionen unten beschrieben werden.

Ebenso dargestellt ist eine zweite Teilhülse (304) mit vier Rastnasen (360), wobei die Nasen nach außen gewandt angeordnet sind, zur Schnapp- Rast- Verbindung mit dem metallischen Formteil (siehe Fig. 3, 700) an dessen zugeordnetem Widerlager (vgl. Fig. 2, 710). Weiterhin weist die zweite Teilhülse (304) vier weitere Rastnasen (350) auf deren Nasen nach innen gewandt angeordnet sind und ihr Widerlager in der Rastkante (320) der ersten Teilhülse (302) finden. Mittels dieser zweiten Schnapp- Rast- Verbindung werden die beiden Teilhülsen (302, 304) aneinander fixiert.

Bei der genannten Fixierung der beiden Teilhülsen (302, 304) zu einer Kunststoffhülse (300) wird weiterhin sowohl die Kontaktfeder (100) als auch das bereits oben geschriebene Metallformteil (200) im Inneren der Kunststoffhülse (300) fixiert. Hierzu dienen die beiden Ausnehmungen (330) am oberen Rand der ersten Teilhülse (302). In dieser ersten Teilhülse (302) ist die Kontaktfeder (100) angeordnet, wobei der stiftartige Fortsatz (110) durch die unter Ausnehmung (310) hindurchreicht und somit die Kontaktfeder (100) nach unten fixiert. Am oberen Federende ragt das Metallformteil (200) mit einem ersten Zapfen (210) ins Innere der Kontaktfeder (100) hinein. Die beiden rechtwinkelig zu dem ersten Zapfen (210) ausgebildeten weiteren Zapfen (230) werden in den Ausnehmungen (330) der ersten Teilhülse (302) angeordnet und durch das Verbinden der beiden Teilhülsen (302, 304) dort fixiert. Somit ergibt sich eine Montageeinheit gebildet aus der Kontaktfeder (100), dem Metallformteil (200) und die beiden Teilen (302, 304) der Kunststoffhülse (300).

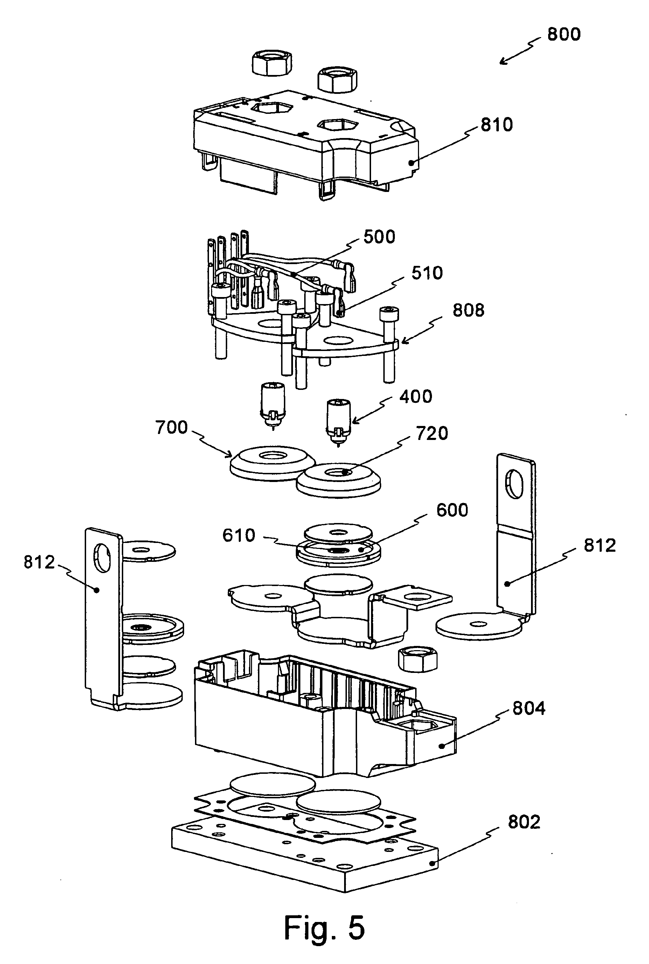

Fig. 5 zeigt eine dreidimensionale Explosionsdarstellung eines Leistungshalbleitermoduls (800) mit einer erfindungsgemäßen Kontakteinrichtung (400). Dargestellt ist ein Leistungshalbleitermodul (800) mit zwei Thyrisoren (600) aufgebaut in Druckkontakttechnik. Auf einer Grundplatte (802) sind in geeigneter Weise angeordnet:
- Isolationsmaterial zur elektrischen Isolation der Strom führenden Teile des Leistungshalbleitermoduls (800) von der Grundplatte (802);
- die beiden Thyristoren (600) mit geeigneten elektrischen Verbindungselementen (812);
- zwei Formkörper (700) zur Aufnahme der Kontakteinrichtung und zur Einleitung des Drucks aus
- einer Druckkontakteinrichtung (808) vergleichbar derer in Fig. 2 beschriebenen und
- ein Gehäuse (804) mit Deckel (810).

Die erfindungsgemäße Kontakteinrichtung (400) ist hier eine Montageeinheit beim Zusammenbau des Leistungshalbleitermoduls (800). Die jeweiligen Kontakteinrichtungen (400) werden hierzu in die zugeordneten Formkörper (700) eingesetzt und rasten an deren Rastkanten (720) ein. Diese Formkörper (700) sind aus einem duroplasten Kunststoff gebildet, da sie nur der Druckeinleitung über die Druckkontakteinrichtung (808) nicht aber der elektrischen Verbindung dienen, die Lastanschlüsse (812) sind hier als metallische Anschlusslaschen ausgeführt. Die elektrische Verbindung zwischen der Kontakteinrichtung (400) nach außen wird wiederum mittels eines Kabels (500) mit damit verbundener Steckhülse (510) gebildet. Hierzu ist die Steckhülse (510) auf dem als Stecker ausgebildeten zweiten Zapfen (220, vgl. Fig. 3) der Kontakteinrichtung (400) angeordnet.

## Patentansprüche

1. Kontakteinrichtung (400) zur Kontaktierung des Steueranschlusses (610) eines Leistungshalbleiterbauelements (600) in einem Leistungshalbleitermodul (800) oder einer Scheibenzelle wobei oberhalb des Leistungshalbleiterbauelements (600) ein Formkörper (700) angeordnet ist, der im Bereich des Steueranschlusses (610) eine durchgehende Ausnehmung (710) aufweist und diese Ausnehmung (710) ein Widerlager (720) aufweist,
wobei die Kontakteinrichtung (400) besteht
aus einer Kontaktfeder (100) mit einem stiftartigen Fortsatz (110) an demjenigen Federende, das den Steueranschluss (610) kontaktiert, und mit einer direkt oder über ein Metallformteil (200) gebildeten Verbindung mit einem Anschlusskabel (500) zur externen Verbindung am anderen Federende und
aus einer Isolierstoffhülse (300) mit darin angeordneter Kontaktfeder (100), wobei diese Isolierstoffhülse (300) mindestens eine Rastnase (360) aufweist die zusammen mit dem Widerlager (720) des Formkörpers (700) eine Schnapp- Rast- Verbindung bildet
wobei die Isolierstoffhülse (300) zweistückig ausgebildet ist und die beiden Teile (302, 304) über eine Schnapp- Rast- Verbindung zueinander angeordnet sind und wobei der zweite, dem Steueranschluss (610) zugewandete Teil (310) der Isolierstoffhülse (300) derart ausgebildet ist, dass die Kontaktfeder (100) gegen Herausfallen in Richtung des Steueranschlusses (610) gesichert ist.

2. Kontakteinrichtung nach Anspruch 1,
wobei die Kontaktfeder (100) als Tonnenfeder ausgebildet ist.

3. Kontakteinrichtung nach Anspruch 1,
wobei das Metallformteil (200) einen ersten Zapfen (210) aufweist, der in den Innenbereich der Kontaktfeder (100) hineinreicht und einen zweiten Zapfen (220) aufweist, der als Stecker ausgebildet ist und mit dem Anschlusskabel (500), das eine Steckerhülse (510) aufweist, mittels einer daraus gebildeten Steckverbindung verbunden ist.

4. Kontakteinrichtung nach Anspruch 1,
wobei das Metallformteil (200) weitere Zapfen (230) rechtwinkelig zu dem ersten (210) und zweiten Zapfen (220) angeordnet aufweist, und das Metallformteil (200) mittels dieser weiteren Zapfen (230) in den beiden Teilen (301, 302) der Isolierstoffhülse (300) gehalten wird.

5. Kontakteinrichtung nach Anspruch 1,
wobei die Kontaktfeder (100) mittels einer Schweiß- oder Lötverbindung mit dem Anschlusskabel (500) verbunden ist.

6. Kontakteinrichtung nach Anspruch 1,
wobei der Formkörper (700) einstückig oder mehrstückig ausgebildet ist, aus einem metallischen Werkstoff besteht und einen Leistungsanschluss (620) des Leistungshalbleiterbauelements (600) elektrisch kontaktiert.

## Claims

1. Contact device (400) for contacting the control terminal (610) of a power semiconductor element (600) in a power semiconductor module (800) or a disc-shaped cell, wherein above the power semiconductor element (600) a shaped body (700) is arranged, which in the region of the control terminal (610) has a recess (710) along the whole length therof and this recess (710) has an abutment (720),
wherein the contacting device (400) consists of
a contact spring (100) with a pin-shaped extension (110) on the spring end that contacts the control terminal (610), and with a connection formed either directly or via a metallic shaped part (200) to a terminal cable (500) to the external connection at the other spring end, and
of an insulating material sleeve (300) with a contact spring (100) arranged therein, wherein this insulating material sleeve (300) has at least one locking nose (360), which together with the abutment (720) of the shaped body (700) forms a snap-in locking connection, wherein the insulating material sleeve (300) is formed from two pieces and the two parts (302, 304) are disposed via a snap-in locking connection with respect to each other, and wherein the second part (310) of the insulating material sleeve (300), facing the control terminal (610), is constructed in such a way that the contact spring (100) is secured to prevent it falling out in the direction of the control terminal (610).

2. Contact device according to Claim 1,
wherein the contact spring (100) is constructed as a barrel spring.

3. Contact device according to Claim 1,
wherein the metallic shaped part (200) has a first spigot (210) which penetrates the interior of the contact spring (100), and a second spigot (220) constructed as a plug and which is connected to the terminal cable (500), which has a plug sleeve (510), by means of a plug connection formed therefrom.

4. Contact device according to Claim 1,
wherein the metallic shaped part (200) has additional spigots (230) arranged at right angles to the first (210) and second spigot (220), and the metallic shaped part (200) is retained by means of these additional spigots (230) in the two parts (301, 302) of the insulating material sleeve (300).

5. Contact device according to Claim 1,
wherein the contact spring (100) is connected to the terminal cable (500) by means of a welded or soldered joint.

6. Contact device according to Claim 1,
wherein the shaped body (700) is constructed of one piece or of multiple pieces, consists of a metallic material and makes electrical contact with a power terminal (620) of the power semiconductor element (600).

## Revendications

1. Dispositif de contact (400) pour l'établissement du contact du branchement de commande (610) d'un composant semi-conducteur de puissance (600) dans un module semi-conducteur de puissance (800) ou une cellule discoïde, un corps moulé (700) étant disposé au-dessus du composant semi-conducteur de puissance (600), lequel corps présente un évidement (710) continu dans la zone du branchement de commande (610) et cet évidement (710) présente un palier de butée (720),
le dispositif de contact (400) comprenant
un ressort de contact (100) avec un prolongement (110) de type broche sur l'extrémité de ressort qui vient en contact avec le branchement de commande (610), et une liaison formée directement ou par l'intermédiaire d'une partie moulée métallique (200) avec un câble de raccordement (500) pour la liaison externe sur l'autre extrémité de ressort et
une douille en matière isolante (300) avec le ressort de contact (100) disposé à l'intérieur, cette douille en matière isolante (300) présentant au moins un ergot d'encliquetage (360) qui forme conjointement avec le palier de butée (720) du corps moulé (700) une liaison à emboîtement et encliquetage, la douille en matière isolante (300) étant conçue en deux parties et les deux parties (302, 304) étant disposées l'une par rapport à l'autre au moyen d'une liaison à emboîtement et à encliquetage, et la seconde partie (310), tournée vers le branchement de commande (610), de la douille en matière isolante (300) étant conçue de telle sorte que le ressort de contact (100) est protégé contre une chute en direction du branchement de commande (610).

2. Dispositif de contact selon la revendication 1,
le ressort de contact (100) étant conçu comme un ressort bombé.

3. Dispositif de contact selon la revendication 1,
la partie moulée métallique (200) présentant un premier tenon (210), qui rentre dans la zone intérieure du ressort de contact (100) et présentant un second tenon (220), qui est conçu comme fiche mâle et est relié au câble de raccordement (500), qui présente un contact femelle (510), au moyen d'une liaison d'enfichage formée à partir de là.

4. Dispositif de contact selon la revendication 1,
la partie moulée métallique (200) présentant d'autres tenons (230) disposés à angle droit par rapport au premier tenon (210) et au second tenon (220), et la partie moulée métallique (200) étant reliée au moyen de ces autres tenons (230) dans les deux parties (301, 302) de la douille en matière isolante (300).

5. Dispositif de contact selon la revendication 1,
le ressort de contact (100) étant relié au moyen d'une liaison soudée ou brasée au câble de raccordement (500).

6. Dispositif de contact selon la revendication 1,
le corps moulé (700) étant conçu d'une seule pièce ou en plusieurs parties, étant à base d'un matériau métallique et établissant un contact électrique avec un branchement de puissance (620) du composant semi-conducteur de puissance (600).
